# FASCICULE DE BREVET EUROPEEN

(11) **EP 1 969 163 B1**
(45) Date de publication et mention de la délivrance du brevet: **16.05.2012**
(21) Numéro de dépôt: 06841868.0
(22) Date de dépôt: 06.12.2006
(51) Int. Cl.: C30B 11/00

(54) **DISPOSITIF ET PROCEDE DE FABRICATION D'UN BLOC DE MATERIAU CRISTALLIN**
VORRICHTUNG UND VERFAHREN ZUR HERSTELLUNG EINES BLOCKS AUS KRISTALLINEM MATERIAL
DEVICE AND PROCESS FOR PRODUCING A BLOCK OF CRYSTALLINE MATERIAL

(30) Priorité: 04.01.2006 FR 0600049
(43) Date de publication de la demande: 17.09.2008
(73) Titulaire: Apollon Solar, 75013 Paris (FR); Cyberstar, 38130 Echirolles (FR); EFD Induction SA, 38170 Seyssinet Pariset (FR)
(72) Inventeur: EINHAUS, Roland, 38300 Bourgoin Jallieu (FR); LISSALDE, François, 38180 Seyssins (FR); RIVAT, Pascal, 38590 Saint Etienne de Saint Geoirs (FR)
(74) Mandataire: Hecké, Gérard
(86) Numéro de dépôt international: PCT/FR2006/002661
(87) Numéro de publication internationale: WO 2007/077305

(56) Documents cités:
- EP-A- 0 781 865
- WO-A-2004/094704
- DE-A1- 2 543 752
- US-A- 4 687 646
- US-A- 6 027 563
- US-B1- 6 299 682
- PATENT ABSTRACTS OF JAPAN vol. 1998, no. 10, 31 août 1998 (1998-08-31) & JP 10 139580 A (JAPAN STEEL WORKS LTD:THE), 26 mai 1998 (1998-05-26)

## Description

### Domaine technique de l'invention

L'invention concerne un dispositif de fabrication d'un bloc de matériau cristallin par cristallisation dirigée, comportant des moyens de chauffage et des moyens de refroidissement disposés de manière à établir un gradient thermique dans un creuset de cristallisation, les moyens de refroidissement comportant un échangeur et une source de chaleur supplémentaire réglable.

### État de la technique

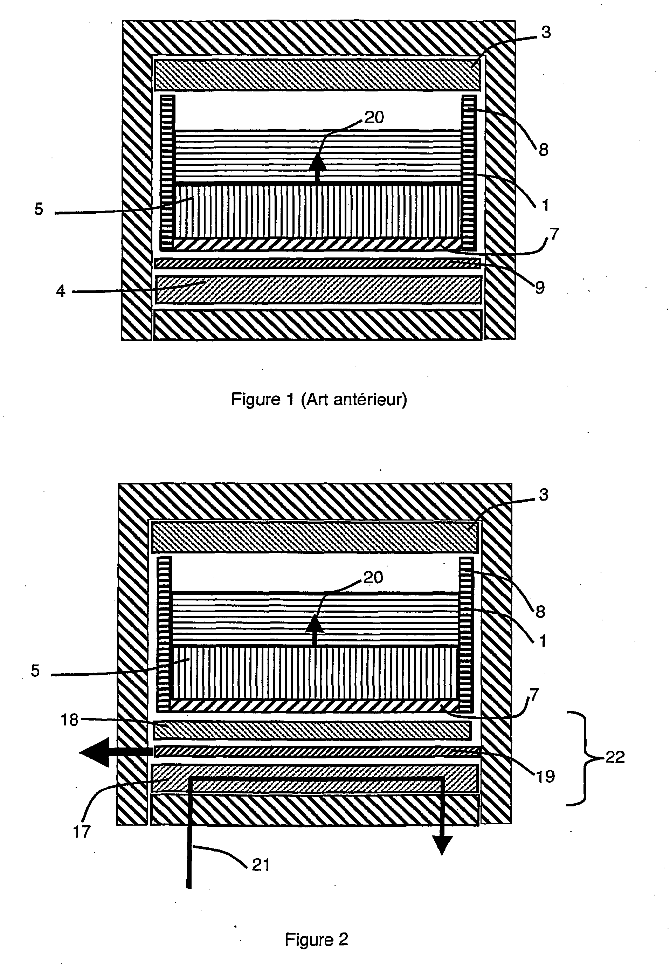

Le document WO2004/094704 décrit un dispositif de fabrication d'un bloc de matériau cristallin par cristallisation dirigée. Ce matériau est typiquement du silicium. Comme représenté à la figure 1, le dispositif comporte un creuset 1 de cristallisation dont le fond 7 permet d'évacuer la chaleur. Le fond 7 du creuset 1 a des propriétés de transfert thermique supérieures à celles des parois 8 latérales. Afin de générer un gradient thermique, un dispositif chauffant 3 et un échangeur de chaleur 4 sont respectivement disposés au-dessus et au-dessous du creuset 1.

Le gradient thermique pour la solidification du silicium nécessite une évaluation de chaleur efficace. Les propriétés anisotropes du creuset 1 permettent d'obtenir des surfaces isothermes sensiblement planes et parallèles. Par conséquent, le front de solidification est également sensiblement plan, parallèlement au fond 7 du creuset 1.

Lors de la cristallisation du silicium, l'épaisseur de la phase solide 5 augmente, de manière à ce que le front de solidification progresse vers le haut en s'éloignant du fond 7 de creuset 1, comme représenté par la flèche 20 à la figure 1. La température de fusion du silicium étant de 1410°C, la surface isotherme de 1410°C s'éloigne alors du fond 7 du creuset 1, ce qui se produit par une diminution de la température au fond 7 du creuset 1 au cours du procédé de cristallisation.

L'augmentation de la quantité du matériau solide au fond 7 du creuset 1 est accompagnée par une augmentation de la résistance thermique. Or, pour maintenir constant le gradient thermique à l'interface solide/liquide, la puissance thermique évacuée par l'échangeur de chaleur 4 doit rester sensiblement constante pendant la durée de solidification. Il est alors nécessaire de prévoir un réglage.

Ainsi, l'échangeur de chaleur 4 comporte, par exemple, un circuit de fluide caloporteur et, selon les applications, le fluide peut être de l'huile de synthèse ou un fluide fonctionnant à haute température, par exemple un gaz sous pression comme l'hélium, ce qui peu être très coûteux lorsque un liquéfacteur d'hélium est nécessaire. Il est possible de faire varier la température du fluide caloporteur dé manière contrôlée, afin d'assurer que la puissance évacuée reste constante pendant la durée de solidification.

Le document WO2004/094704, par exemple, décrit un feutre 9 de graphite disposé entre le fond 7 du creuset 1 et les moyens de refroidissement 4, comme illustré à la figure 1. Le feutre 9 de graphite est comprimé pendant la solidification du silicium. Ainsi, l'épaisseur du feutre 9 de graphite diminue et sa conductivité thermique augmente. Le transfert thermique par conductivité du feutre 9 de graphite peut alors être contrôlé au cours du procédé de solidification. On peut également enlever progressivement le feutre 9 de graphite pour contrôler le refroidissement. Le gradient thermique dans le creuset 1 est typiquement contrôlé et maintenu à une valeur comprise entre 8°C/cm et 30°C/cm.

Il existe également des systèmes de refroidissement à eau. Cependant, il est difficile de contrôler la température sur une gamme de températures importante, à moins d'utiliser la chaleur latente de vaporisation de l'eau, ce qui est compliqué à mettre en oeuvre.

Le document US6299682 décrit un appareil pour fabriquer un lingot de silicium pour applications photovoltaïques. L'appareil comporte un dispositif de chauffage disposé en dessus d'un creuset et des moyens de refroidissement disposés sous le creuset. Sous le creuset est également disposée une source de chaleur pour contrôler la chaleur évacuée en bas du creuset

### Objet de l'invention

L'invention a pour but de remédier à ces inconvénients et, en particulier, d'assurer un réglage efficace de la température, tout en réduisant les coûts de mise en oeuvre du dispositif.

Selon l'invention, ce but est atteint par les revendications annexées et, plus particulièrement, par le fait que les moyens de refroidissement sont constitués par une spire d'induction refroidie par un liquide de refroidissement circulant à l'intérieur de la spire d'induction et par un suscepteur d'induction électriquement conducteur disposé entre le creuset et la spire d'induction.

L'invention a également pour but un procédé de fabrication d'un bloc de matériau cristallin par cristallisation dirigée utilisant un dispositif selon l'invention, le procédé comportant :
- le chauffage du creuset par le haut et le refroidissement du creuset par le bas, pour établir le gradient thermique dans le creuset de cristallisation, et
- le contrôle de l'évacuation de la chaleur du creuset vers le bas par l'intermédiaire de l'échangeur et par l'intermédiaire du réglage de la source de chaleur supplémentaire réglable,
les moyens de refroidissement étant constitués par une spire d'induction refroidie par un liquide de refroidissement circulant à l'intérieur de la spire d'induction et par un suscepteur d'induction électriquement conducteur disposé entre le creuset et la spire d'induction,
- le procédé comportant simultanément le chauffage par l'intermédiaire de la spire d'induction et le refroidissement par l'intermédiaire du liquide de refroidissement circulant à l'intérieur de la spire d'induction, et
- le procédé comportant, pendant qu'un front de solidification progresse dans le creuset en s'éloignant du suscepteur, la réduction progressive du chauffage par l'intermédiaire de la réduction de l'alimentation électrique de la spire d'induction.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 montre un dispositif de fabrication d'un bloc de matériau cristallin par cristallisation dirigée selon l'art antérieur.
Les figures 2 et 3 montrent, en coupe, deux modes de réalisation particuliers du dispositif selon l'invention.
La figure 4 illustre, en vue de dessus, un mode de réalisation particulier d'un suscepteur d'un dispositif selon l'invention.

### Description de modes particuliers de réalisation

Le dispositif de fabrication représenté à la figure 2 comporte une source de chaleur 3 et un système de refroidissement 22 disposé de manière à établir un gradient thermique dans le creuset 1 de cristallisation. Le système de refroidissement 22 comporte un échangeur 17 et une source de chaleur supplémentaire réglable 18, par exemple des résistances chauffantes, un chauffage par infrarouge ou tout autre moyen de chauffage réglable approprié. L'échangeur 17 comporte de préférence un circuit de refroidissement d'eau représenté schématiquement par la flèche 21. L'échangeur 17 peut notamment être étendu sur toute la largeur du creuset 1.

Ainsi, l'évacuation de la chaleur du creuset peut être contrôlée, tout en bénéficiant des avantages d'un échangeur à puissance constante, notamment la mise en oeuvre simple.

Le dispositif peut également comporter un feutre 19 amovible disposé au-dessus de l'échangeur 17 et sous la source de chaleur supplémentaire réglable 18, ce qui permet de faire écran au rayonnement thermique entre la source de chaleur 18 et l'échangeur 17 et, ainsi, de contrôler davantage l'évacuation de chaleur du creuset 1. En introduisant le feutre 19 amovible entre la source 18 et l'échangeur 17, l'évacuation de chaleur est diminuée, tandis que le retrait du feutre 19 autorise une évacuation directe du rayonnement émis par la source 18 en direction de l'échangeur 17.

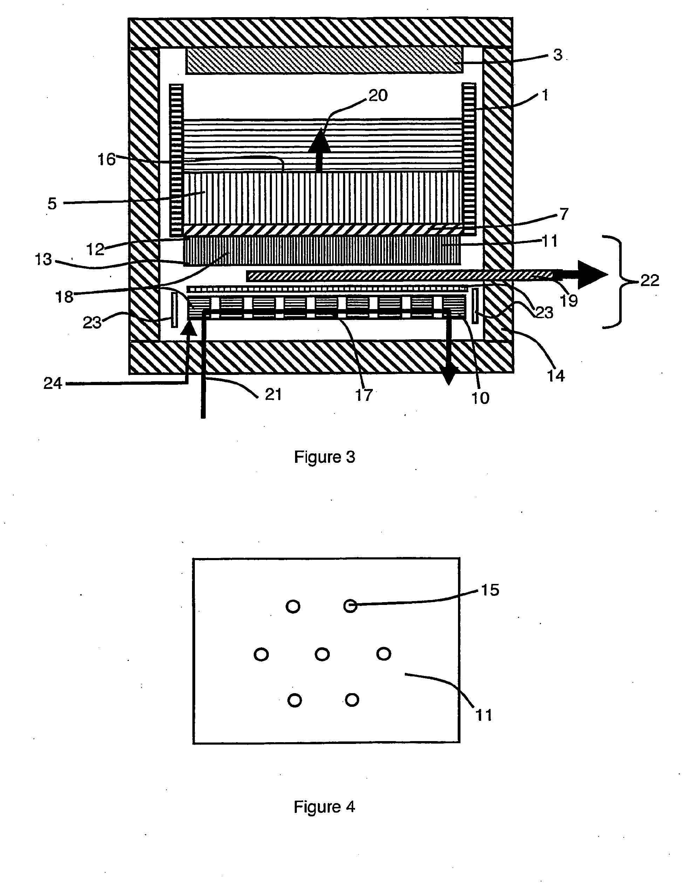

Dans le mode de réalisation préférentiel représenté à la figure 3, le système de refroidissement 22 comporte une spire d'induction 10 refroidie par un liquide de refroidissement circulant à l'intérieur de la spire d'induction 10 et un suscepteur d'induction 11 électriquement et thermiquement conducteur disposé entre le creuset 1 et la spire d'induction 10.

Ainsi, l'ensemble de la spire d'induction 10 et du suscepteur d'induction 11 constituent la source de chaleur supplémentaire réglable 18. Le réglage est effectué par l'intermédiaire de l'alimentation électrique 24 (voir figure 3) de la spire d'induction 10. En même temps, l'échangeur 17 est constitué par l'ensemble de la spire d'induction 10 et de son circuit de refroidissement par un liquide de refroidissement circulant à l'intérieur de la spire d'induction 10, illustré par la flèche 21 à la figure 3.

Au-dessus du creuset 1 est disposée une source de chaleur 3, par exemple constituée par des résistances chauffantes, par une spire d'induction supplémentaire et son suscepteur supplémentaire ou par tout autre moyen de chauffage approprié, comme un chauffage par infrarouge, par exemple. Sous le creuset est disposée la spire d'induction 10. Le suscepteur 11 d'induction est disposé entre le creuset 1 et la spire d'induction 10. Le creuset 1 comporte, de préférence, un fond 7 transparent en silice amorphe sans impuretés, permettant de transmettre le rayonnement infrarouge. Lorsqu'un feutre amovible 19 est utilisé comme décrit précédemment, le feutre amovible 19 peut être installé entre la spire d'induction 10 et le suscepteur 11.

Les spires d'induction selon l'art antérieur sont typiquement refroidies par un liquide de refroidissement circulant à l'intérieur de la spire d'induction. Or, classiquement, les spires d'induction de chauffage ne sont pas en contact thermique avec l'objet destiné à être chauffé, voire isolées thermiquement de cet objet. Le refroidissement n'agit donc que sur la spire elle-même, et ne peut pas agir sur le dispositif à chauffer.

Le suscepteur 11 est, de préférence, en un matériau thermiquement conducteur et absorbant le rayonnement infrarouge, par exemple en graphite ou en carbure de silicium, qui sont des conducteurs et de bon corps noirs. Ainsi, la chaleur émise par le fond 7 du creuset 1 est absorbée par la face 12 du suscepteur disposée en regard du creuset 1, conduite à travers le suscepteur 11 et réémise par la face 13 du suscepteur 11 disposée en regard de la spire d'induction 10. La spire d'induction 10 permet d'évacuer la chaleur. Le suscepteur 11 peut constituer un support pour le creuset 1 et permet d'obtenir un bon échange thermique entre le suscepteur 11 et le creuset 1. La spire d'induction 10 est, de préférence, disposée dans une zone électriquement isolée, en utilisant par exemple des plaques en silice 23, permettant d'éviter des court-circuits et la formation d'étincelles vers le graphite 14 environnant. Comme représenté à la figure 3, les plaques en silice 23 sont disposées autour de la spire d'induction 10.

Le suscepteur 11 peut simplement être constitué par une plaque plane. Dans un mode de réalisation particulier, le suscepteur 11 comporte des zones 15 de plus faible conductivité électrique surfacique permettant de réduire localement le chauffage d'induction et permettant aussi de favoriser localement l'évacuation de la chaleur du creuset 1 vers la spire d'induction 10. Les zones du creuset 1 disposées en regard des zones 15 de plus faible conductivité électrique surfacique sont, par conséquent, moins chauffées et constituent, ainsi, des centres de nucléation pour la cristallisation. De plus, les zones du creuset 1 disposées en regard des zones 15 de plus faible conductivité électrique surfacique sont mieux refroidies, car les zones 15 de plus faible conductivité électrique surfacique favorisent localement l'évacuation de la chaleur du creuset 1 vers la spire d'induction 10.

Les zones 15 de plus faible conductivité électrique surfacique sont, par exemple, constituées par des trous disposés dans le suscepteur 11, comme représenté à la figure 4. Les zones 15 de plus faible conductivité électrique surfacique peuvent également être constituées par une matériau ayant une plus faible conductivité électrique que le matériau du suscepteur 11 ou par une zone ayant une plus faible épaisseur que le suscepteur. La dimension latérale des zones 15 de plus faible conductivité électrique surfacique est, de préférence, égale ou supérieure à l'épaisseur du suscepteur. L'écart entre les zones 15 de plus faible conductivité électrique surfacique est, par exemple de 10cm pour un suscepteur d'une dimension de quelques dizaines de décimètres.

Un procédé de fabrication d'un bloc de matériau cristallin par cristallisation dirigée utilisant un dispositif selon l'invention, comporte le chauffage du creuset 1 par le haut et le refroidissement du creuset 1 par le bas, pour établir le gradient thermique dans le creuset 1 de cristallisation. Le procédé comporte, de plus, le contrôle de l'évacuation de la chaleur du creuset 1 vers le bas par l'intermédiaire de l'échangeur 17 et par l'intermédiaire du réglage de la source de chaleur supplémentaire réglable 18. L'échangeur 17 peut notamment fonctionner en régime constant, ce qui simplifie la mise en oeuvre de l'échangeur 17.

Le procédé de fabrication d'un bloc de matériau cristallin par cristallisation dirigée utilisant le dispositif selon l'invention, peut notamment comporter le chauffage par l'intermédiaire de la spire d'induction 10 et son suscepteur, d'une part, et, simultanément, le refroidissement par l'intermédiaire du liquide de refroidissement circulant à l'intérieur de la spire d'induction 10, d'autre part. Pendant qu'un front de solidification 16 progresse dans le creuset 1 en s'éloignant du suscepteur 11 vers le haut, comme représenté à la figure 3 par la flèche 20, le chauffage est progressivement réduit par l'intermédiaire de la réduction de l'alimentation électrique de la spire d'induction 10, tandis que le liquide de refroidissement peut circuler de manière constante à l'intérieur de la spire d'induction 10.

Le procédé peut également comporter, avant la cristallisation, une étape de fusion du matériau destiné à être cristallisée, utilisant la source de chaleur 3 et la source de chaleur supplémentaire réglable 18, comportant, par exemple, la spire d'induction 10 et son suscepteur 11. Ceci permet notamment de faire fondre complètement le matériau destiné à être cristallisé.

L'invention n'est pas limitée aux modes de réalisation représentés. En particulier, le gradient n'est pas nécessairement établi de haut en bas, et peut être orienté selon un axe quelconque, par exemple horizontal ou incliné. Dans ce dernier cas, les moyens de chauffage et de refroidissement sont respectivement disposés de part et d'autre de la zone de gradient.

## Revendications

1. Dispositif de fabrication d'un bloc de matériau cristallin par cristallisation dirigée, comportant des moyens de chauffage (3) et des moyens de refroidissement disposés de manière à établir un gradient thermique dans un creuset (1) de cristallisation, les moyens de refroidissement (22) comportant un échangeur (17) et une source de chaleur supplémentaire réglable, dispositif **caractérisé en ce que** les moyens de refroidissement (22) comportent une spire d'induction (10) refroidie par un liquide de refroidissement circulant à l'intérieur de la spire d'induction (10) et un suscepteur d'induction (11) électriquement conducteur disposé entre le creuset (1) et la spire d'induction (10).

2. Dispositif selon la revendication 1, **caractérisé en ce que** le suscepteur (11) est en un matériau conducteur thermiquement, et absorbant le rayonnement infrarouge.

3. Dispositif selon la revendication 2, **caractérisé en ce que** le suscepteur (11) est en graphite ou en carbure de silicium.

4. Dispositif selon l'une quelconque des revendications 1 à 3, **caractérisé en ce que** le suscepteur (11) constitue un support pour le creuset (1).

5. Dispositif selon l'une quelconque des revendications 1 à 4, **caractérisé en ce que** le suscepteur (11) comporte des zones (15) de plus faible conductivité électrique surfacique permettant de réduire localement le chauffage d'induction et permettant de favoriser localement l'évacuation de la chaleur du creuset (1) vers la spire d'induction (10).

6. Dispositif selon la revendication 5, **caractérisé en ce que** les zones (15) de plus faible conductivité électrique surfacique sont constituées par
- des trous,
- par une matériau ayant une plus faible conductivité électrique que le matériau du suscepteur
- ou par une zone ayant une plus faible épaisseur que le suscepteur (11).

7. Dispositif selon l'une quelconque des revendications 1 à 6, **caractérisé en ce qu'**il comporte des plaques en silice (23) disposées autour de la spire d'induction (10).

8. Dispositif selon l'une quelconque des revendications 1 à 7, **caractérisé en ce que** le creuset (1) comporte un fond (7) transparent en silice amorphe sans impuretés.

9. Dispositif selon l'une quelconque des revendications 1 à 8, **caractérisé en ce qu'**il comporte un feutre amovible (19) disposé au-dessus de l'échangeur (17).

10. Procédé de fabrication d'un bloc de matériau cristallin par cristallisation dirigée utilisant un dispositif selon l'une quelconque des revendications 1 à 9, procédé comportant :
- le chauffage du creuset (1) par le haut et le refroidissement du creuset (1) par le bas, pour établir le gradient thermique dans le creuset (1) de cristallisation, et
- le contrôle de l'évacuation de la chaleur du creuset (1) vers le bas par l'intermédiaire de l'échangeur (17) et par l'intermédiaire du réglage de la source de chaleur supplémentaire réglable (18),
procédé **caractérisé en ce que**,
les moyens de refroidissement (22) étant constitués par une spire d'induction (10) refroidie par un liquide de refroidissement circulant à l'intérieur de la spire d'induction (10) et par un suscepteur d'induction (11) électriquement conducteur disposé entre le creuset (1) et la spire d'induction (10),
- le procédé comporte simultanément le chauffage par l'intermédiaire de la spire d'induction (10) et le refroidissement par l'intermédiaire du liquide de refroidissement circulant à l'intérieur de la spire d'induction (10), et
- le procédé comporte, pendant qu'un front de solidification (16) progresse dans le creuset (1) en s'éloignant du suscepteur (11), la réduction progressive du chauffage par l'intermédiaire de la réduction de l'alimentation électrique de la spire d'induction (10).

11. Procédé selon la revendication 10, **caractérisé en ce qu'**il comporte, avant la cristallisation, une étape de fusion du matériau destiné à être cristallisée, utilisant les moyens de chauffage (3) et la source de chaleur supplémentaire réglable (18).

## Claims

1. An equipment for the fabrication of a block of crystalline material by directional crystallization comprising heating means (3) and cooling means arranged such as to establish a temperature gradient in a crystallization crucible (1), the cooling means (22) comprising a heat exchanger (17) and an adjustable additional heat source, a device **characterized in that** the cooling means (22) comprise an induction coil (10) cooled by a cooling liquid circulating in the induction oil (10) and an electrically conducting induction susceptor (11) positioned between the crucible (1) and induction coil (10).

2. The device according t claim 1, **characterized in that** the susceptor (11) is made from thermally conducting material absorbing infrared radiation.

3. The device according t claim 2, **characterized in that** the susceptor (11) is made from graphite or sil con carbide.

4. The device according t any one of claims 1 to 3, **characterized in that** the susceptor (11) forms a support for the crucible (1).

5. The device according any one of claims 1 to 4, **characterized in that** the susceptor (11) comprises zones (15) of lower surface electric conductivity enabling induction heating to be locally reduced and also locally provoking heat removal from the crucible (1) to the induction coil (10).

6. The device according t claim 5, **characterized in that** the zones (15) of lower electric surface conductivity are formed
- by holes,
- by a material having a lower electric conductivity than the material of the susceptor
- or by a zone having a smaller thickness than the susceptor (11).

7. The device according t any one of claims 1 to 6, **characterized in that** it comprises silica plates (23) arranged around the induction coil (10).

8. The device according to any one of claims 1 to 7, **characterized in that** the crucible (1) comprises a transparent bottom (7) made from impurity-free amorphous silica.

9. The device according to any one of claims 1 to 8, **characterized in that** it comprises a removable felt (19) positioned above the heat exchanger (17).

10. A process for the fabrication of a block of crystalline material by directional crystallization using an equipment according to any one of claims 1 to 9, a process comprising:
- heating the crucible (1) via the top and cooling the crucible (1) via the bottom to establish the temperature gradient in the crystallization crucible (1), and
- controlling the heat removal from the crucible (1) via the bottom by means of the heat exchanger (17) and by means of regulation of the adjustable additional heat source (18),
a process **characterized in that**,
the cooling means (22) being formed by an induction coil (10) cooled by a cooling liquid circulating in the induction coil (10) and by an electrically conducting induction susceptor (11) arranged between the crucible (1) and the induction coil (10),
- the process simultaneously comprising heating by means of the induction coil (10) and cooling by means of the cooling liquid circulating in the induction coil (10), and
- the process comprising progressive reduction of the heating by means of reduction of the electric power supply of the induction coil (10), while a solidification front (16) progresses in the crucible (1) moving away from the susceptor (11).

11. The process according to claim 10, **characterized in that**, before crystallization, it comprises a melting step of the material to be crystallized, using the heating means (3) and the adjustable additional heat source (18).

## Patentansprüche

1. Vorrichtung zur Herstellung eines Blocks aus kristallinem Material durch gerichtete Kristallisation, die Mittel zum Erhitzen (3) und Mittel zum Abkühlen umfasst, welche so angeordnet sind, dass in einem Kristallisationstiegel (1) ein Temperaturgradient hergestellt wird, welche Mittel zum Abkühlen (22) einen Wärmetauscher (17) und eine zusätzliche regulierbare Wärmequelle umfassen. Selbige Vorrichtung ist **dadurch gekennzeichnet**, die **dadurch gekennzeichnet ist, dass** die Mittel zum Abkühlen (22) eine Induktionsspule (10), die mittels einer Kühlflüssigkeit gekühlt wird, welche innerhalb der Induktionsspule (10) zirkuliert, sowie einen elektrisch leitenden Induktionssuszeptor (11) umfassen, der zwischen dem Tiegel (1) und der Induktionsspule (10) angeordnet ist.

2. Vorrichtung nach Anspruch 1, **dadurch gekennzeichnet, dass** der Suszeptor (11) aus wärmeleitfähigem Material besteht und Infrarotstrahlung absorbiert.

3. Vorrichtung nach Anspruch 2, **dadurch gekennzeichnet, dass** der Suszeptor (11) aus Graphit oder Siliziumkarbid besteht.

4. Vorrichtung nach einem der Ansprüche 1 bis 3, **dadurch gekennzeichnet, dass** der Suszeptor (11) eine Standfläche für den Tiegel (1) bildet.

5. Vorrichtung nach einem der Ansprüche 1 bis 4, **dadurch gekennzeichnet, dass** der Suszeptor (11) Bereiche (15) geringerer elektrischer Obertlächenleitfähigkeit aufweist, die eine lokal reduzierte Induktionserwärmung und die lokale Abführung der Wärme aus dem Tiegel (1) zur Induktionsspule (10) hin verursachen.

6. Vorrichtung nach Anspruch 5, **dadurch gekennzeichnet, dass** die Bereiche (15) mit geringerer elektrischer Oberflächenleitfähigkeit
- aus Löchern,
- aus einem Material mit einer geringeren elektrischen Leitfähigkeit als das Materials des Suszeptors
- oder aus einem Bereich mit einer geringeren Dicke als der Suszeptor (11) bestehen.

7. Vorrichtung nach einem der Ansprüche 1 bis 6, **dadurch gekennzeichnet, dass** sie SiO2/Quarz-platten (23) umfasst, die um die Induktionswindung (10) herum angeordnet sind.

8. Vorrichtung nach einem der Ansprüche 1 bis 7, **dadurch gekennzeichnet, dass** der Tiegel (1) einen transparenten Boden (7) aus amorphem Quarz ohne Beimengungen umfasst.

9. Vorrichtung nach einem der Ansprüche 1 bis 8, **dadurch gekennzeichnet, dass** sie einen entfernbaren Filz (19) umfasst, der über dem Wärmetauscher (17) angeordnet ist.

10. Herstellungsverfahren für einen Block aus kristallinem Material mittels gerichteter Kristallisation, bei dem eine Vorrichtung nach einem der Ansprüche 1 bis 9 verwendet wird. Das Verfahren umfasst:
- Erhitzung des Tiegels (1) von oben und Abkühlung des Tiegels (1) von unten, um den Temperaturgradienten in dem Kristallisationstiegel (1) herzustellen, und
- Steuerung der Wärmeableitung aus dem Tiegel (1) nach unten mittels des Wärmetauschers (17) und mittels der Regelung der zusätzlichen regulierbaren Wärmequelle (18),
- Ein Verfahren, das **dadurch gekennzeichnet ist, dass**, nachdem die Mittel zum Abkühlen (22) von einer Induktionsspule (10) gebildet werden, die mittels einer Kühlflüssigkeit gekühlt wird, die im Inneren der Induktionsspule (10) zirkuliert, und mittels eines elektrisch leitenden Induktionssuszeptors (11), der zwischen dem Tiegel (1) und der Induktionsspule (10) angeordnet ist,
- Ein Verfahren welches gleichzeitiges Erhitzen mittels der Induktionsspule (10) und Abfühlen mittels der innerhalb der Induktionsspule (10) zirkulierenden Kühlflüssigkeit umfasst .
- Ein Verfahren, das die allmähliche Verringerung der Wärme mittels einer Reduzierung der elektrischen Versorgung der Induktionsspule (10) umfasst während eine Erstarrungsfront (16) sich in dem Tiegel (1) vom Suszeptor(11) aus fortbewegt.

11. Verfahren nach Anspruch 10, **dadurch gekennzeichnet, dass** es vor der Kristallisation eine Etappe umfasst, in der das zu kristallisierende Material geschmolzen wird, und zwar mit Hilfe der Mittel zum Erhitzen (3) und der zusätzlichen regulierbaren Wärmequelle (18).
